# EUROPEAN PATENT APPLICATION

(11) **EP 2 490 247 A1**
(43) Date of publication of application: **22.08.2012**
(21) Application number: 10823289.3
(22) Date of filing: 29.09.2010
(51) Int. Cl.: H01L 21/02, H01L 21/28, H01L 21/336, H01L 29/12, H01L 29/78

(54) **SILICON CARBIDE SUBSTRATE MANUFACTURING METHOD AND SILICON CARBIDE SUBSTRATE**

(30) Priority: 13.10.2009 JP 2009236204; 13.10.2009 JP 2009236211; 29.07.2010 JP 2010170489
(71) Applicant: Sumitomo Electric Industries, Ltd., Chuo-ku Osaka-shi Osaka 541-0041 (JP)
(72) Inventor: NISHIGUCHI, Taro, Itami-shi Hyogo 664-0016 (JP); MASUDA, Takeyoshi, Osaka-shi Osaka 554-0024 (JP); SASAKI, Makoto, Itami-shi Hyogo 664-0016 (JP); HARADA, Shin, Osaka-shi Osaka 554-0024 (JP); NAMIKAWA, Yasuo, Osaka-shi Osaka 554-0024 (JP); FUJIWARA, Shinsuke, Itami-shi Hyogo 664-0016 (JP)
(74) Representative: Grünecker, Kinkeldey, Stockmair & Schwanhäusser
(86) International application number: PCT/JP2010/066964
(87) International publication number: WO 2011/046021

(57) **Abstract**

A method for manufacturing a silicon carbide substrate includes the steps of: preparing a base substrate (10) made of silicon carbide and a SiC substrate (20) made of single-crystal silicon carbide; forming a Si film (30) made of silicon on a main surface of the base substrate (10); fabricating a stacked substrate by placing the SiC substrate (20) on and in contact with the Si film (30); and connecting the base substrate (10) and the SiC substrate (20) to each other by heating the stacked substrate to convert, into silicon carbide, at least a region making contact with the base substrate (10) and a region making contact with the SiC substrate (20) in the Si film (30).

## Description

### TECHNICAL FIELD

The present invention relates to a method for manufacturing a silicon carbide substrate, and the silicon carbide substrate, more particularly, a method for manufacturing a silicon carbide substrate, and the silicon carbide substrate, each of which achieves reduced cost of manufacturing a semiconductor device using the silicon carbide substrate.

### BACKGROUND ART

In recent years, in order to achieve high breakdown voltage, low loss, and utilization of semiconductor devices under a high temperature environment, silicon carbide (SiC) has begun to be adopted as a material for a semiconductor device. Silicon carbide is a wide band gap semiconductor having a band gap larger than that of silicon, which has been conventionally widely used as a material for semiconductor devices. Hence, by adopting silicon carbide as a material for a semiconductor device, the semiconductor device can have a high breakdown voltage, reduced on-resistance, and the like. Further, the semiconductor device thus adopting silicon carbide as its material has characteristics less deteriorated even under a high temperature environment than those of a semiconductor device adopting silicon as its material, advantageously.

Under such circumstances, various studies have been conducted on methods for manufacturing silicon carbide crystals and silicon carbide substrates used for manufacturing of semiconductor devices, and various ideas have been proposed (for example, see M. Nakabayashi, et al., "Growth of Crack-free 100mm-diameter 4H-SiC Crystals with Low Micropipe Densities, Mater. Sci. Forum, vols. 600-603, 2009, p.3-6 (Non-Patent Literature 1)).

### CITATION LIST

### NON PATENT LITERATURE

NPL 1: M. Nakabayashi, et al., "Growth of Crack-free 100 mm-diameter 4H-SiC Crystals with Low Micropipe Densities, Mater. Sci. Forum, vols. 600-603, 2009, p.3-6

### SUMMARY OF INVENTION

### TECHNICAL PROBLEM

However, silicon carbide does not have a liquid phase at an atmospheric pressure. In addition, crystal growth temperature thereof is 2000°C or greater, which is very high. This makes it difficult to control and stabilize growth conditions. Accordingly, it is difficult for a silicon carbide single-crystal to have a large diameter while maintaining its quality to be high. Hence, it is not easy to obtain a high-quality silicon carbide substrate having a large diameter. This difficulty in fabricating such a silicon carbide substrate having a large diameter results in not only increased manufacturing cost of the silicon carbide substrate but also fewer semiconductor devices produced for one batch using the silicon carbide substrate. Accordingly, manufacturing cost of the semiconductor devices is increased, disadvantageously. It is considered that the manufacturing cost of the semiconductor devices can be reduced by effectively utilizing a silicon carbide single-crystal, which is high in manufacturing cost, as a substrate.

In view of this, an object of the present invention is to provide a method for manufacturing a silicon carbide substrate, and the silicon carbide substrate, each of which achieves reduced cost of manufacturing a semiconductor device using the silicon carbide substrate.

### SOLUTION TO PROBLEM

A method for manufacturing a silicon carbide substrate in the present invention includes the steps of: preparing a base substrate made of silicon carbide and a SiC substrate made of single-crystal silicon carbide; forming a Si film made of silicon on and in contact with a main surface of the base substrate; fabricating a stacked substrate by placing the SiC substrate on and in contact with the Si film; and connecting the base substrate and the SiC substrate to each other by heating the stacked substrate to convert, into silicon carbide, at least a region making contact with the base substrate and a region making contact with the SiC substrate in the Si film.

As described above, it is difficult for a high-quality silicon carbide single-crystal to have a large diameter. Meanwhile, for efficient manufacturing in a process of manufacturing a semiconductor device using a silicon carbide substrate, a substrate provided with predetermined uniform shape and size is required. Hence, even when a high-quality silicon carbide single-crystal (for example, silicon carbide single-crystal having a small defect density) is obtained, a region that cannot be processed into such a predetermined shape and the like by cutting, etc., may not be effectively used.

To address this, in the method for manufacturing the silicon carbide substrate of the present invention, the SiC substrate made of single-crystal silicon carbide different from that of the base substrate is connected onto the base substrate. Thus, the silicon carbide substrate can be manufactured, for example, in the following manner. That is, the base substrate formed of low-quality silicon carbide crystal having a large defect density is processed to have the predetermined shape and size. On such a base substrate, a high-quality silicon carbide single-crystal not shaped into the predetermined shape and the like is employed as the SiC substrate. Then, they are connected to each other. The silicon carbide substrate manufactured through such a process has the predetermined uniform shape and size, thereby achieving efficient manufacturing of semiconductor devices. Further, the silicon carbide substrate manufactured through such a process utilizes the SiC substrate formed of high-quality silicon carbide single-crystal and having not been used because it cannot be processed into a desired shape and the like conventionally. Using such a silicon carbide substrate, semiconductor devices can be manufactured, thereby effectively using silicon carbide single-crystal. Furthermore, in the method for manufacturing the silicon carbide substrate in the present invention, at least the portions of the Si film are converted into silicon carbide, thereby obtaining an intermediate layer allowing the base substrate and the SiC substrate to be firmly connected to each other. Hence, the silicon carbide substrate can be handled as one freestanding substrate. As such, according to the method for manufacturing the silicon carbide substrate in the present invention, there can be manufactured a silicon carbide substrate that allows for reduced cost of manufacturing semiconductor devices using the silicon carbide substrate.

Preferably, the method for manufacturing the silicon carbide substrate further includes the step of smoothing at least one of main surfaces of the base substrate and the SiC substrate, which are to be disposed face to face with each other with the Si film interposed therebetween in the step of fabricating the stacked substrate, the step of smoothing being performed before the step of fabricating the stacked substrate.

Thus, the surface to serve as the connection surface is smoothed in advance, thereby allowing the base substrate and the SiC substrate to be connected to each other more securely. In order to attain further secure connection between the base substrate and the SiC substrate, it is preferable to smooth both the main surfaces of the base substrate and the SiC substrate, which are to be disposed face to face with the Si film interposed therebetween in the step of fabricating the stacked substrate.

Preferably, in the method for manufacturing the silicon carbide substrate, the Si film formed in the step of forming the Si film has a thickness of not less than 10 nm and not more than 1 µm.

If the thickness of the Si film formed on the base substrate is less than 10 nm and surface smoothness of each of the surfaces of the base substrate and the SiC substrate is not sufficiently high, the Si film to be formed between the base substrate and the SiC substrate becomes discontinuous, which may result in failure in achieving firm connection between the base substrate and the SiC substrate. In contrast, if the thickness of the Si film is more than 1 µm, the thickness of the intermediate layer (layer obtained by converting at least the portions of the Si film into silicon carbide) in the thickness of the silicon carbide substrate to be manufactured becomes large. This may result in decreased characteristics particularly when fabricating a vertical type device in which a current flows in the thickness direction of silicon carbide substrate 1. Hence, the Si film formed preferably has a thickness of not less than 10 nm and not more than 1 µm.

Preferably, in the method for manufacturing the silicon carbide substrate, in the step of connecting the base substrate and the SiC substrate to each other, the stacked substrate is heated in an atmosphere including a gas containing carbon.

Accordingly, carbon is supplied to the Si film not only from the base substrate and the SiC substrate but also from the atmosphere, thereby achieving efficient conversion of silicon of the Si film into silicon carbide.

Preferably, in the method for manufacturing the silicon carbide substrate, in the step of fabricating the stacked substrate, a plurality of the SiC substrates are arranged side by side when viewed in a planar view.

As described above, it is difficult for a high-quality silicon carbide single-crystal to have a large diameter. To address this, the plurality of SiC substrates each obtained from a high-quality silicon carbide single-crystal are arranged side by side on the base substrate having a large diameter when viewed in a planar view, thereby obtaining a silicon carbide substrate that can be handled as a substrate having a high-quality SiC layer and a large diameter. By using such a silicon carbide substrate, the process of manufacturing a semiconductor device can be improved in efficiency. It should be noted that in order to further improve the efficiency of the process of manufacturing a semiconductor device, it is preferable that adjacent ones of the plurality of SiC substrates are arranged in contact with one another. More specifically, for example, the plurality of SiC substrates are preferably arranged in contact with one another in the form of a matrix.

In the method for manufacturing the silicon carbide substrate, in the stacked substrate, a main surface of the SiC substrate opposite to the base substrate has an off angle of not less than 50° and not more than 65° relative to a {0001} plane.

By growing single-crystal silicon carbide of hexagonal system in the <0001> direction, a high-quality single-crystal can be fabricated efficiently. From such a silicon carbide single-crystal grown in the <0001> direction, a silicon carbide substrate having a main surface corresponding to the {0001} plane can be obtained efficiently. Meanwhile, by using a silicon carbide substrate having a main surface having an off angle of not less than 50° and not more than 65° relative to the plane orientation of {0001}, a semiconductor device with high performance may be manufactured.

Specifically, for example, it is general that a silicon carbide substrate used for fabrication of a MOSFET has a main surface having an off angle of approximately 8° relative to the plane orientation of {0001}. An epitaxial growth layer is formed on this main surface and an oxide film, an electrode, and the like are formed on this epitaxial growth layer, thereby obtaining a MOSFET. In this MOSFET, a channel region is formed in a region including an interface between the epitaxial growth layer and the oxide film. However, in the MOSFET having such a structure, a multiplicity of interface states are formed around the interface between the epitaxial growth layer and the oxide film, i.e., the location in which the channel region is formed, due to the substrate's main surface having an off angle of approximately 8° relative to the {0001} plane. This hinders traveling of carriers, thus decreasing channel mobility.

To address this, in the stacked substrate, by setting the main surface of the SiC substrate opposite to the base substrate to have an off angle of not less than 50° and not more than 65° relative to the {0001} plane, the silicon carbide substrate to be manufactured will have a main surface having an off angle of not less than 50° and not more than 65° relative to the {0001} plane. This reduces formation of interface states. Hence, a MOSFET with reduced on-resistance can be fabricated.

In the method for manufacturing the silicon carbide substrate, in the stacked substrate, the main surface of the SiC substrate opposite to the base substrate has an off orientation forming an angle of not more than 5° relative to the <1-100> direction.

The <1-100> direction is a representative off orientation in a silicon carbide substrate. Variation in the off orientation resulting from variation in a slicing process of the process of manufacturing the substrate is adapted to be not more than 5°, which allows an epitaxial growth layer to be formed readily on the silicon carbide substrate.

In the above-described method for manufacturing the silicon carbide substrate, in the stacked substrate, the main surface of the SiC substrate opposite to the base substrate can have an off angle of not less than -3° and not more than 5° relative to a {03-38} plane in the <1-100> direction.

Accordingly, channel mobility can be further improved in the case where a MOSFET is fabricated using the silicon carbide substrate. Here, setting the off angle at not less than -3° and not more than +5° relative to the plane orientation of {03-38} is based on a fact that particularly high channel mobility was obtained in this set range as a result of inspecting a relation between the channel mobility and the off angle.

Further, the "off angle relative to the {03-38} plane in the <1-100> direction" refers to an angle formed by an orthogonal projection of a normal line of the above-described main surface to a flat plane defined by the <1-100> direction and the <0001> direction, and a normal line of the {03-38} plane. The sign of positive value corresponds to a case where the orthogonal projection approaches in parallel with the <1-100> direction whereas the sign of negative value corresponds to a case where the orthogonal projection approaches in parallel with the <0001> direction.

It should be noted that the main surface preferably has a plane orientation of substantially {03-38}, and the main surface more preferably has a plane orientation of {03-38}. Here, the expression "the main surface has a plane orientation of substantially {03-38}" is intended to encompass a case where the plane orientation of the main surface of the substrate is included in a range of off angle such that the plane orientation can be substantially regarded as {03-38} in consideration of processing accuracy of the substrate. In this case, the range of off angle is, for example, a range of off angle of +2° relative to {03-38}. Accordingly, the above-described channel mobility can be further improved.

In the method for manufacturing the silicon carbide substrate, in the stacked substrate, the main surface of the SiC substrate opposite to the base substrate has an off orientation forming an angle of not more than 5° relative to the <11-20> direction.

The <11-20> direction is a representative off orientation in a silicon carbide substrate, as with the <1-100> direction. Variation in the off orientation resulting from variation in the slicing process of the process of manufacturing the substrate is adapted to be ±5°, which allows an epitaxial growth layer to be formed readily on the SiC substrate.

In the method for manufacturing the silicon carbide substrate, the base substrate may be made of single-crystal silicon carbide, and in the step of fabricating the stacked substrate, the stacked substrate may be fabricated such that main surfaces of the base substrate and the SiC substrate, which are disposed face to face with each other with the Si film interposed therebetween, have the same plane orientation.

A thermal expansion coefficient of single-crystal silicon carbide is anisotropic depending on its crystal plane. Hence, when surfaces corresponding to crystal planes greatly different from each other in thermal expansion coefficient are connected to each other, stress resulting from the difference in thermal expansion coefficient is applied between the base substrate and the SiC substrate. This stress may cause strains or cracks of the silicon carbide substrate in the manufacturing of the silicon carbide substrate or in the process of manufacturing semiconductor devices using the silicon carbide substrate. To address this, the silicon carbide single-crystals to constitute the above-described connection surface are adapted to have the same plane orientation, thereby reducing the stress. It should be noted that the state in which "the main surfaces of the base substrate and the SiC substrate have the same plane orientation" does not need to correspond to a state in which the plane orientations of the main surfaces are strictly the same, and may correspond to a state in which they are substantially the same. More specifically, when the crystal plane constituting the main surface of the base substrate forms an angle of not more than 1° relative to the crystal plane constituting the main surface of the SiC substrate, it can be said that the main surfaces of the base substrate and the SiC substrate has substantially the same plane orientation.

In the method for manufacturing the silicon carbide substrate, in the stacked substrate, the main surface of the SiC substrate opposite to the base substrate has an off angle of not less than 1° and not more than 60° relative to the {0001} plane.

By growing a silicon carbide single-crystal of hexagonal system in the <0001> direction as described above, a high-quality single-crystal can be fabricated efficiently. From such a silicon carbide single-crystal grown in the <0001> direction, SiC substrates can be obtained relatively effectively so far as the surface does not have a large off angle relative to the {0001} plane, specifically, has an off angle of 60° or smaller. Meanwhile, with the off angle being 1° or greater, a high-quality epitaxial growth layer can be formed on such a SiC substrate.

In the method for manufacturing the silicon carbide substrate, the step of connecting the base substrate and the SiC substrate to each other is performed without polishing main surfaces of the base substrate and the SiC substrate before the step of connecting the base substrate and the SiC substrate to each other, the main surfaces of the base substrate and the SiC substrate being to be disposed face to face with each other in the step of connecting the base substrate and the SiC substrate to each other.

Accordingly, the manufacturing cost of the silicon carbide substrate can be reduced. Here, as described above, the main surfaces of the base substrate and the SiC substrate, which are to be disposed face to face with each other in the step of connecting the base substrate and the SiC substrate to each other, may not be polished. However, for removal of damaged layers in the vicinity of surfaces formed by slicing upon fabricating the substrate, it is preferable to perform the step of connecting the base substrate and the SiC substrate to each other, after performing a step of removing the damaged layers by means of etching, for example.

The method for manufacturing the silicon carbide substrate may further include the step of polishing a main surface of the SiC substrate, the main surface corresponding to a main surface of the SiC substrate to be opposite to the base substrate.

This allows a high-quality epitaxial growth layer to be formed on the main surface of the SiC substrate opposite to the base substrate. As a result, a semiconductor device can be manufactured which includes the high-quality epitaxial growth layer as an active layer, for example. Namely, by employing such a step, a silicon carbide substrate can be obtained which allows for manufacturing of a high-quality semiconductor device including the epitaxial growth layer formed on the SiC substrate. Here, the main surface of the SiC substrate may be polished after connecting the base substrate and the SiC substrate to each other, or before connecting the base substrate and the SiC substrate to each other by previously polishing the main surface of the SiC substrate, which is to be opposite to the base substrate.

A silicon carbide substrate according to the present invention includes: a base layer made of silicon carbide; an intermediate layer formed on and in contact with the base layer; and a SiC layer made of single-crystal silicon carbide and disposed on and in contact with the intermediate layer. The intermediate layer contains silicon carbide at least at its region adjacent to the base layer and its region adjacent to the SiC layer and connects the base layer and the SiC layer to each other. The silicon carbide in the region adjacent to the base layer and the region adjacent to the SiC layer may be amorphous.

In the silicon carbide substrate of the present invention, the SiC layer made of single-crystal silicon carbide different from that of the base layer is connected onto the base layer. Hence, for example, a low-quality silicon carbide crystal having a large defect density is processed into predetermined shape and size suitable for manufacturing of semiconductor devices to serve as the base layer, whereas a high-quality silicon carbide single-crystal having a suitable shape and the like for manufacturing of semiconductor devices is disposed on the base layer as the SiC layer. Such a silicon carbide substrate have the predetermined uniform shape and size, thus attaining effective manufacturing of semiconductor devices. Further, semiconductor devices can be manufactured using such a silicon carbide substrate that employs the high-quality SiC layer thus having a difficulty in being processed into the shape and the like suitable for manufacturing of semiconductor devices, thereby effectively utilizing the silicon carbide single-crystal. Further, in the silicon carbide substrate of the present invention, the base layer and the SiC layer are connected to each other and are unified by the intermediate layer containing silicon carbide at its region adjacent to the base layer and its region adjacent to the SiC layer. Hence, the silicon carbide substrate can be handled as one freestanding substrate. As such, according to the silicon carbide substrate of the present invention, there can be provided a silicon carbide substrate allowing for reduced cost of manufacturing semiconductor devices using the silicon carbide substrate.

In the silicon carbide substrate, preferably, a plurality of the SiC layers are arranged side by side when viewed in a planar view.

Thus, the plurality of SiC layers each obtained from a high-quality silicon carbide single-crystal are arranged side by side on the base layer having a large diameter when viewed in a planar view, thereby obtaining a silicon carbide substrate that can be handled as a substrate having a high-quality SiC layer and a large diameter. By using such a silicon carbide substrate, the process of manufacturing a semiconductor device can be improved in efficiency. It should be noted that in order to improve the efficiency of the process of manufacturing a semiconductor device, it is preferable that adjacent ones of the plurality of SiC layers are arranged in contact with one another. More specifically, for example, the plurality of SiC layers are preferably arranged in contact with one another in the form of a matrix.

In the silicon carbide substrate, the base layer may be made of single-crystal silicon carbide. In this case, no micro pipe of the base layer is preferably propagated to the SiC layer.

As the base layer, single-crystal silicon carbide having relatively many defects such as micro pipes can be employed. In employing it, the micro pipes formed in the base layer are prevented from being propagated to the SiC layer, thereby allowing a high-quality epitaxial growth layer to be formed on the SiC layer. The silicon carbide substrate of the present invention can be fabricated by connecting a separately grown SiC layer onto the base layer instead of directly growing the SiC layer on the base layer. Thus, the micro pipes formed in the base layer can be readily prevented from being propagated to the SiC layer.

In the silicon carbide substrate, a main surface of the SiC layer opposite to the base layer has an off angle of not less than 50° and not more than 65° relative to a {0001} plane.

As such, in the silicon carbide substrate of the present invention, the main surface of the SiC layer opposite to the base layer is adapted to have an off angle of not less than 50° and not more than 65° relative to the {0001} plane, thereby reducing formation of interface states around an interface between an epitaxial growth layer and an oxide film, i.e., a location where a channel region is formed upon forming a MOSFET using the silicon carbide substrate, for example. Accordingly, a MOSFET with reduced on-resistance can be fabricated.

In the silicon carbide substrate, the main surface of the SiC layer opposite to the base layer may have an off orientation forming an angle of not more than 5° relative to the <1-100> direction.

The <1-100> direction is a representative off orientation in a silicon carbide substrate. Variation in the off orientation resulting from variation in a slicing process of the process of manufacturing the substrate is adapted to be 5° or smaller, which allows an epitaxial growth layer to be formed readily on the silicon carbide substrate.

In the silicon carbide substrate, the main surface of the SiC layer opposite to the base layer has an off angle of not less than -3° and not more than 5° relative to the {03-38} plane in the <1-100> direction.

Accordingly, channel mobility can be further improved in the case where a MOSFET is fabricated using the silicon carbide substrate. Here, the "off angle relative to the {03-38} plane in the <1-100> direction" refers to an angle formed by an orthogonal projection of a normal line of the above-described main surface to a flat plane defined by the <1-100> direction and the <0001> direction, and a normal line of the {03-38} plane. The sign of positive value corresponds to a case where the orthogonal projection approaches in parallel with the <1-100> direction whereas the sign of negative value corresponds to a case where the orthogonal projection approaches in parallel with the <0001> direction.

Further, the main surface preferably has a plane orientation of substantially {03-38}, and the main surface more preferably has a plane orientation of {03-38}. Here, the expression "the main surface has a plane orientation of substantially {03-38}" is intended to encompass a case where the plane orientation of the main surface of the substrate is included in a range of off angle such that the plane orientation can be substantially regarded as {03-38} in consideration of processing accuracy of the substrate. In this case, the range of off angle is, for example, a range of off angle of ±2° relative to {03-38}. Accordingly, the above-described channel mobility can be further improved.

In the silicon carbide substrate, the main surface of the SiC layer opposite to the base layer has an off orientation forming an angle of not more than 5° relative to the <11-20> direction.

The <11-20> direction is a representative off orientation in a silicon carbide substrate, as with the <1-100> direction. Variation in the off orientation resulting from variation in a slicing process of the process of manufacturing the substrate is adapted to be ±5°, which allows an epitaxial growth layer to be formed readily on silicon carbide substrate 1.

In the silicon carbide substrate, the base layer may be made of single-crystal silicon carbide. In this case, the main surfaces of the base layer and the SiC layer, which are disposed face to face with each other with the intermediate layer interposed therebetween, preferably has the same plane orientation.

This suppresses stress resulting from anisotropy in thermal expansion coefficient depending on a crystal plane to exert between the base layer and the SiC layer. It should be noted that the state in which "the main surfaces of the base layer and the SiC layer have the same plane orientation" does not need to correspond to a state in which the plane orientations of the main surfaces are strictly the same, and may correspond to a state in which they are substantially the same. More specifically, it can be said that the main surfaces of the base layer and the SiC layer has substantially the same plane orientation as long as the crystal plane constituting the main surface of the base layer forms an angle of 1° or smaller relative to the crystal plane constituting the SiC layer.

In the silicon carbide substrate, the main surface of the SiC layer opposite to the base layer may have an off angle of not less than 1° and not more than 60° relative to a {0001} plane.

As described above, from the silicon carbide single-crystal grown in the <0001> direction, single-crystal silicon carbide having a large off angle relative to the {0001} plane, specifically, having an off angle of 60° or smaller can be obtained relatively efficiently and can be employed as the SiC layer. Meanwhile, with the off angle being 1° or greater, a high-quality epitaxial growth layer can be readily formed on such a SiC substrate.

In the silicon carbide substrate, the main surface of the SiC layer opposite to the base layer may be polished. This allows a high-quality epitaxial growth layer to be formed on the main surface of the SiC layer opposite to the base layer. As a result, a semiconductor device can be manufactured which includes the high-quality epitaxial growth layer as an active layer, for example. Namely, by employing such a structure, the silicon carbide substrate can be obtained which allows for manufacturing of a high-quality semiconductor device including the epitaxial layer formed on the SiC layer.

### ADVANTAGEOUS EFFECTS OF INVENTION

As apparent from the description above, a method for manufacturing a silicon carbide substrate, and the silicon carbide substrate in the present invention provides a method for manufacturing a silicon carbide substrate, and the silicon carbide substrate, each of which achieves reduced cost of manufacturing a semiconductor device using the silicon carbide substrate.

### BRIEF DESCRIPTION OF DRAWINGS

Fig. 1 is a schematic cross sectional view showing a structure of a silicon carbide substrate.
Fig. 2 is a schematic cross sectional view showing the structure of the silicon carbide substrate having an epitaxial layer formed thereon.
Fig. 3 is a flowchart schematically showing a method for manufacturing the silicon carbide substrate.
Fig. 4 is a schematic cross sectional view for illustrating the method for manufacturing the silicon carbide substrate.
Fig. 5 is a schematic cross sectional view showing another structure of the silicon carbide substrate.
Fig. 6 is a schematic plan view showing the another structure of the silicon carbide substrate.
Fig. 7 is a schematic cross sectional view showing still another structure of the silicon carbide substrate.
Fig. 8 is a schematic cross sectional view showing a structure of a vertical type MOSFET.
Fig. 9 is a flowchart schematically showing a method for manufacturing the vertical type MOSFET.
Fig. 10 is a schematic cross sectional view for illustrating the method for manufacturing the vertical type MOSFET.
Fig. 11 is a schematic cross sectional view for illustrating the method for manufacturing the vertical type MOSFET.
Fig. 12 is a schematic cross sectional view for illustrating the method for manufacturing the vertical type MOSFET.
Fig. 13 is a schematic cross sectional view for illustrating the method for manufacturing the vertical type MOSFET.

### DESCRIPTION OF EMBODIMENTS

The following describes embodiments of the present invention with reference to figures. It should be noted that in the below-mentioned figures, the same or corresponding portions are given the same reference characters and are not described repeatedly.

### (First Embodiment)

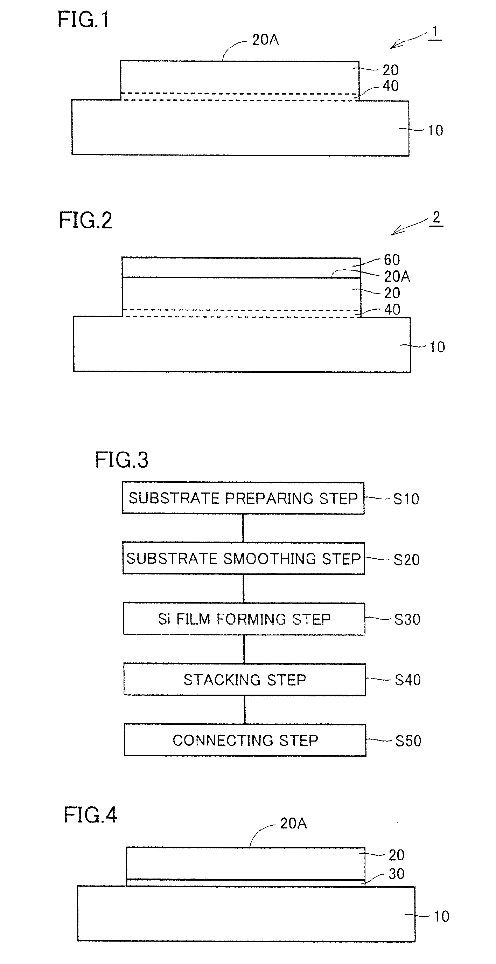

Referring to Fig. 1, silicon carbide substrate 1 in the present embodiment includes: a base layer 10 made of silicon carbide; an intermediate layer 40 formed on and in contact with base layer 10; and a SiC layer 20 made of single-crystal silicon carbide and disposed on and in contact with intermediate layer 40. Intermediate layer 40 contains silicon carbide at least at its region adjacent to base layer 10 and its region adjacent to SiC layer 20, and connects base layer 10 and SiC layer 20 to each other. The silicon carbide in each of the region adjacent to base layer 10 and the region adjacent to SiC layer 20 may be amorphous.

Then, when an epitaxial growth layer 60 made of single-crystal silicon carbide is formed on main surface 20A of SiC layer 20 opposite to base layer 10 as shown in Fig. 2, stacking faults that can be generated in base layer 10 are not propagated to epitaxial growth layer 60. Accordingly, stacking fault density in epitaxial growth layer 60 can be readily made smaller than that in base layer 10.

In silicon carbide substrate 1 in the present embodiment, SiC layer 20, which is made of single-crystal silicon carbide different from that of base layer 10, is connected onto base layer 10. Hence, for example, a low-quality silicon carbide crystal having a large defect density is processed to have a shape and a size suitable for the process of manufacturing a semiconductor device and is then employed as base layer 10. On the other hand, a high-quality silicon carbide single-crystal not having a shape suitable for the process of manufacturing a semiconductor device can be disposed on base layer 10 as SiC layer 20. This silicon carbide substrate 1 is uniformly shaped and sized appropriately, thereby achieving efficient manufacturing of semiconductor devices. Further, because the high-quality silicon carbide single-crystal having a difficulty in being processed into a shape suitable for the process of manufacturing can be used as SiC layer 20 in silicon carbide substrate 1 to manufacture a semiconductor device, thereby effectively utilizing the silicon carbide single-crystal. Further, in silicon carbide substrate 1, base layer 10 and SiC layer 20 are unified by being connected to each other by intermediate layer 40 containing silicon carbide at its regions adjacent to base layer 10 and adjacent to SiC layer 20. Hence, silicon carbide substrate 1 can be handled as one freestanding substrate. As such, silicon carbide substrate 1 described above allows for reduced cost in manufacturing semiconductor devices. Because intermediate layer 40 thus includes silicon carbide at least at its regions adjacent to base layer 10 and adjacent to SiC layer 20, base layer 10 and SiC layer 20 are connected to each other more firmly.

Here, base layer 10 can adopt a structure from various structures as long as it is made of silicon carbide. For example, base layer 10 may be of, for example, polycrystal silicon carbide or a sintered compact of silicon carbide. Alternatively, base layer 10 may be made of single-crystal silicon carbide. In this case, it is preferable that no micro pipes in base layer 10 are propagated to SiC layer 20. Further, in the case where silicon carbide substrate 1 is employed to manufacture a semiconductor device in which a current flows in the thickness direction of silicon carbide substrate 1, base layer 10 preferably has a small resistivity. Specifically, base layer 10 preferably has a resistivity of 50 mΩcm or smaller, more preferably, 10 mΩcm or smaller.

In the case where single-crystal silicon carbide containing relatively many defects such as micro pipes is employed as base layer 10, a high-quality epitaxial growth layer can be formed on SiC layer 20 by preventing the micro pipes formed in base layer 10 from being propagated to SiC layer 20. Silicon carbide substrate 1 in the present embodiment can be fabricated by connecting SiC layer 20, which has not been grown on base layer 10 and has grown separately therefrom, onto base layer 10. Hence, it is easy to prevent the micro pipes formed in base layer 10 from being propagated to SiC layer 20.

Further, in the case where base layer 10 is made of single-crystal silicon carbide, it is preferable that the main surface of base layer 10, which faces SiC layer 20 with intermediate layer 40 interposed therebetween, has the same plane orientation as that of the main surface of SiC layer 20. This suppresses stress resulting from anisotropy in thermal expansion coefficient to exert between base layer 10 and SiC layer 20.

Further, in silicon carbide substrate 1 described above, main surface 20A of SiC substrate 20 opposite to base layer 10 may have an off angle of not less than 50° and not more than 65° relative to the {0001} plane. Accordingly, when fabricating a MOSFET using silicon carbide substrate 1, formation of interface states is reduced around an interface between an epitaxial growth layer and an oxide film thereof, i.e., a location where a channel region is formed. In this way, the MOSFET fabricated has reduced on-resistance.

Further, in silicon carbide substrate 1, the off orientation of main surface 20A may form an angle of 5° or smaller relative to the <1-100> direction. The <1-100> direction is a representative off orientation in a silicon carbide substrate. Variation in the off orientation resulting from variation in a slicing process of the process of manufacturing the substrate is adapted to be 5° or smaller, which allows an epitaxial growth layer to be formed readily on silicon carbide substrate 1.

Further, in the silicon carbide substrate, main surface 20A may have an off angle of not less than -3° and not more than 5° relative to the {03-38} plane in the <1-100> direction. Accordingly, channel mobility can be further improved in the case where a MOSFET is fabricated using silicon carbide substrate 1.

Meanwhile, in silicon carbide substrate 1, the off orientation of main surface 20A may form an angle of 5° or smaller relative to the <11-20> direction. The <11-20> direction is a representative off orientation in a silicon carbide substrate, as with the <1-100> direction. Variation in the off orientation resulting from variation in a slicing process of the process of manufacturing the substrate is adapted to be ±5°, which allows an epitaxial growth layer to be formed readily on silicon carbide substrate 1.

Further, in silicon carbide substrate 1, main surface 20A may have an off angle of not less than 1° and not more than 60° relative to the {0001} plane. This allows a silicon carbide single-crystal usable as SiC layer 20 to be obtained effectively, and facilitates formation of a high-quality epitaxial growth layer on SiC layer 20.

Further, for ease of handling as a freestanding substrate, silicon carbide substrate 1 preferably has a thickness of 300 µm or greater. Further, when silicon carbide substrate 1 is employed to fabricate a power device, SiC layer 20 preferably has a polytype of 4H.

Further, in silicon carbide substrate 1, main surface 20A of SiC layer 20 opposite to base layer 10 is preferably polished. This allows for formation of a high-quality epitaxial growth layer on main surface 20A. As a result, a semiconductor device can be manufactured which includes the high-quality epitaxial growth layer as an active layer, for example. Namely, by employing such a structure, silicon carbide substrate 1 can be obtained which allows for manufacturing of a high-quality semiconductor device including the epitaxial layer formed on SiC layer 20.

The following describes an exemplary method for manufacturing silicon carbide substrate 1 described above. Referring to Fig. 3, in the method for manufacturing the silicon carbide substrate in the present embodiment, first, as a step (S 10), a substrate preparing step is performed. In this step (S10), referring to Fig. 4, a base substrate 10 formed of silicon carbide and a SiC substrate 20 formed of single-crystal silicon carbide are prepared. SiC substrate 20 has the main surface, which will be main surface 20A of SiC layer 20 that will be obtained by this manufacturing method (see Fig. 1). Hence, on this occasion, the plane orientation of the main surface of SiC substrate 20 is selected in accordance with desired plane orientation of main surface 20A. Here, for example, a SiC substrate 20 having a main surface corresponding to the {03-38} plane is prepared.

Meanwhile, for base substrate 10, a substrate having an impurity density greater than that of SiC substrate 20 is employed, such as a substrate having an impurity density greater than 2 × 10¹⁹ cm⁻³. Here, the term "impurity" refers to an impurity introduced to generate majority carriers in the semiconductor substrates, i.e., base substrate 10 and SiC substrate 20. A usable example thereof is nitrogen. Further, base substrate 10 preferably has a diameter of 2 inches or greater, more preferably, of 6 inches or greater in order to achieve efficient fabrication of semiconductor devices using silicon carbide substrate 1. Further, in order to prevent generation of cracks between base substrate 10 and SiC substrate 20 in the process of manufacturing semiconductor devices using silicon carbide substrate 1, it is preferable to reduce a difference in thermal expansion coefficient therebetween. Further, in order to reduce a difference between base substrate 10 and SiC substrate 20 in physical properties such as thermal expansion coefficient, base substrate 10 and SiC substrate 20 preferably have the same crystal structure (the same polytype).

Next, a substrate smoothing step is performed as a step (S20). In this step (S20), the respective main surfaces (connection surface) of base substrate 10 and SiC substrate 20, which are to be disposed face to face with each other with a Si film interposed therebetween in a subsequent step (S40), are smoothed by polishing, for example. It should be noted that although this step (S20) is not an essential step, by performing this step, the Si film will be formed uniformly in a below-described step (S30) to allow base substrate 10 and SiC substrate 20 to be connected to each other more securely in a step (S50). Further, variation of the thickness of each of base substrate 10 and SiC substrate 20 (difference between the maximum value and the minimum value of the thickness) is preferably reduced as much as possible, specifically, is preferably 10 µm or smaller.

Meanwhile, step (S20) may be omitted, i.e., step (S30) may be performed without polishing the main surfaces of base substrate 10 and SiC substrate 20, which are to face each other. This reduces manufacturing cost of silicon carbide substrate 1. Further, for removal of damaged layers located in surfaces formed by slicing upon fabrication of base substrate 10 and SiC substrate 20, a step of removing the damaged layers may be performed by, for example, etching instead of step (S20) or after step (S20), and then step (S30) described below may be performed.

Next, a Si film forming step is performed as step (S30). In this step (S30), referring to Fig. 4, Si film 30 made of silicon is formed on the main surface of base substrate 10. Si film 30 can be formed using a method such as a sputtering method, a deposition method, a liquid phase epitaxy, or a vapor phase epitaxy. Further, in forming Si film 30, nitrogen, phosphorus, aluminum, boron, or the like can be doped as an impurity. Further, Si film 30 may be adapted to contain titanium to improve solid solubility of carbon in Si film 30 to facilitate conversion thereof into silicon carbide in the below-described step (S50).

Next, a stacking step is performed as step (S40). In this step (S40), referring to Fig. 4, SiC substrate 20 is placed on and in contact with Si film 30 formed on and in contact with the main surface of base substrate 10, thereby fabricating a stacked substrate.

Next, as step (S50), a connecting step is performed. In step (S50), base substrate 10 and SiC substrate 20 are connected to each other by heating the stacked substrate. More specifically, for example, the stacked substrate is heated for not less than 1 hour and not more than 30 hours to fall within a range of temperature from 1300°C to 1800°C. In this way, carbon is supplied from base substrate 10 and SiC substrate 20 to Si film 30, thereby converting at least portions of Si film 30 into silicon carbide. By performing the heating under a gas containing carbon atoms, for example, under an atmosphere including a hydrocarbon gas such as propane, ethane, or ethylene, carbon is supplied from the atmosphere to Si film 30 to facilitate the conversion of silicon constituting Si film 30 into silicon carbide. By heating the stacked substrate in this way, at least the region in contact with base substrate 10 and the region in contact with SiC substrate 20 in Si film 30 are converted into silicon carbide, thereby connecting base substrate 10 and SiC substrate 20 to each other. As a result, silicon carbide substrate 1 shown in Fig. 1 is obtained. Further, the atmosphere upon the heating in step (S50) may be inert gas atmosphere. In the case where the atmosphere is the inert gas atmosphere, the inert gas atmosphere preferably contains at least one selected from a group consisting of argon, helium, and nitrogen. Further, in this step (S50), the stacked substrate may be heated in an atmosphere obtained by reducing pressure of the atmospheric air. This reduces manufacturing cost of silicon carbide substrate 1.

Thus, in the method for manufacturing silicon carbide substrate 1 in the present embodiment, SiC substrate 20 made of single-crystal silicon carbide different from that of base substrate 10 is connected onto base substrate 10. As such, base substrate 10 formed of an inexpensive, low-quality silicon carbide crystal having a large defect density can be processed to have a shape and a size suitable for manufacturing of semiconductor devices, whereas a high-quality silicon carbide single-crystal not having a shape and the like suitable for manufacturing of semiconductor devices can be disposed as SiC substrate 20 on base substrate 10. Silicon carbide substrate 1 manufactured through such a process has the predetermined uniform shape and size. This allows for efficient manufacturing of semiconductor devices. Further, silicon carbide substrate 1 manufactured through such a process utilizes such a high-quality SiC substrate 20 (SiC layer 20) to manufacture a semiconductor device, thereby effectively utilizing silicon carbide single-crystal. Further, in the method for manufacturing silicon carbide substrate 1 in the present invention, base substrate 10 and SiC substrate 20 are firmly connected to each other by intermediate layer 40 formed by converting at least the portions of Si film 30 into silicon carbide. Hence, silicon carbide substrate 1 can be handled as one freestanding substrate. As such, according to the method for manufacturing silicon carbide substrate 1 in the present embodiment, there can be manufactured a silicon carbide substrate 1 that allows for reduced cost of manufacturing semiconductor devices using silicon carbide substrate 1.

Further, by epitaxially growing single-crystal silicon carbide on silicon carbide substrate 1 to form an epitaxial growth layer 60 on main surface 20A of SiC substrate 20, a silicon carbide substrate 2 shown in Fig. 2 can be manufactured.

Here, in step (S30), the Si film formed preferably has a thickness of not less than 10 nm and not more than 1 µm. If the thickness of Si film 30 formed on base substrate 10 is less than 10 nm and surface smoothness of each of the surfaces of base substrate 10 and SiC substrate 20 is not sufficiently high, Si film 30 to be formed between base substrate 10 and SiC substrate 20 becomes discontinuous, which may lead to failure in achieving firm connection between base substrate 10 and SiC substrate 20. In contrast, if the thickness of Si film 30 is more than 1 µm, the thickness of intermediate layer 40 in the thickness of silicon carbide substrate 1 becomes large. This may result in decreased characteristics particularly when fabricating a vertical type device in which a current flows in the thickness direction of silicon carbide substrate 1. Thus, Si film 30 formed preferably has a thickness of not less than 10 nm and not more than 1 µm.

Further, in step (S40), the stacked substrate is preferably fabricated such that the plane orientations of the main surfaces of base substrate 10 and SiC substrate 20, which face each other with Si film 30 interposed therebetween, coincide with each other. This suppresses stress resulting from anisotropy in thermal expansion coefficient to exert between base substrate 10 and SiC substrate 20.

Further, in step (S50), Si film 30 (intermediate layer 40) may be doped with a desired impurity by adding nitrogen, trimethylaluminum, diborane, phosphine, or the like in the atmosphere in which the stacked substrate is heated.

In the above-described embodiment, it has been illustrated that: in the stacked substrate fabricated in step (S40), main surface 20A of SiC substrate 20 opposite to base substrate 10 has an off orientation corresponding to the <1-100> direction, and main surface 20A thereof corresponds to the {03-38} plane. However, instead of this, the main surface may have an off orientation forming an angle of 5° or smaller relative to the <11-20> direction. Further, main surface 20A may have an off angle of not less than 1° and not more than 60° relative to the {0001} plane.

Further, the above-described method for manufacturing silicon carbide substrate 1 in the present embodiment may further include a step of polishing the main surface of SiC substrate 20 that corresponds to main surface 20A of SiC substrate 20 opposite to base substrate 10 in the stacked substrate. Accordingly, a silicon carbide substrate 1 is manufactured in which main surface 20A of SiC layer 20 opposite to base layer 10 has been polished. Here, the step of polishing may be performed before or after connecting base substrate 10 and SiC substrate 20 to each other, as long as the step of polishing is performed after step (S10).

### (Second Embodiment)

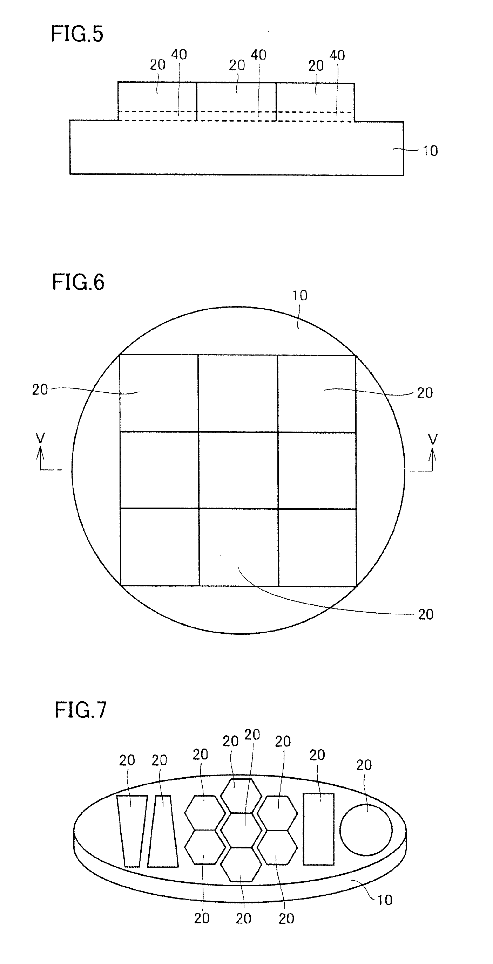

The following describes another embodiment of the present invention, i.e., a second embodiment. Referring to Fig. 5, Fig. 6, and Fig. 1, a silicon carbide substrate 1 in the second embodiment has basically the same configuration and provides basically the same effects as those of silicon carbide substrate 1 in the first embodiment. However, silicon carbide substrate 1 in the second embodiment is different from that of the first embodiment in that a plurality of SiC layers 20 are arranged side by side when viewed in a planar view.

Namely, referring to Fig. 5 and Fig. 6, in silicon carbide substrate 1 of the second embodiment, the plurality of SiC layers 20 are arranged side by side when viewed in a planar view. In other words, the plurality of SiC layers 20 are arranged along main surface 10A of base layer 10. More specifically, the plurality of SiC layers 20 are arranged in the form of a matrix on base layer 10 such that adjacent SiC layers 20 are in contact with each other. Accordingly, silicon carbide substrate 1 of the present embodiment can be handled as a substrate having high-quality SiC layers 20 and a large diameter. Utilization of such a silicon carbide substrate 1 allows for efficient manufacturing process of semiconductor devices. It should be noted that silicon carbide substrate 1 in the second embodiment can be manufactured in a similar way to that in the first embodiment by arranging the plurality of SiC substrates 20 side by side on Si film 30 in step (S40) in the first embodiment. It should be noted that there may be formed a space between adjacent SiC layers (SiC substrates) 20. The space is preferably 100 µm or smaller, more preferably, 10 µm or smaller.

Further, in the second embodiment, it has been illustrated that the plurality of SiC layers 20 each having a planar shape of square (quadrangle) are disposed on base laver 10, but the shape of each of SiC layers 20 is not limited to this. Specifically, referring to Fig. 7, the planar shapes of SiC layers 20 can be any shapes such as a hexagon shape, a trapezoidal shape, a rectangular shape, and a circular shape, or may be a combination thereof.

### (Third Embodiment)

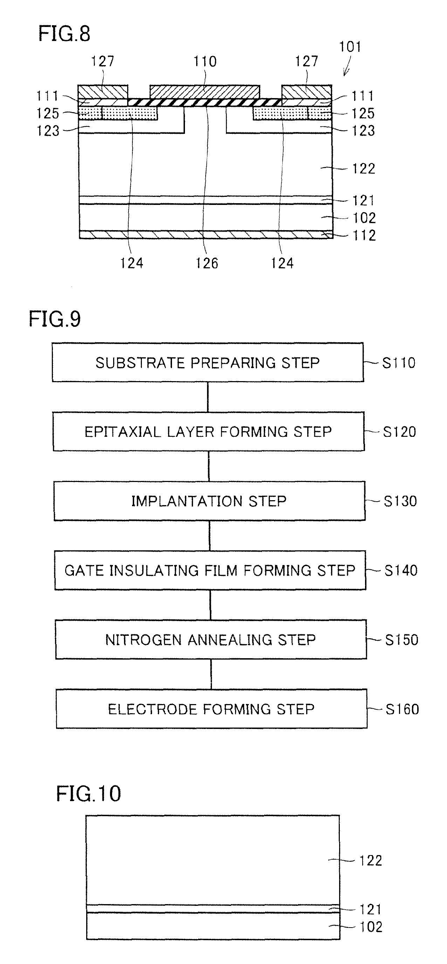

As a third embodiment, the following describes one exemplary semiconductor device fabricated using the above-described silicon carbide substrate of the present invention. Referring to Fig. 8, a semiconductor device 101 according to the present invention is a DiMOSFET (Double Implanted MOSFET) of vertical type, and has a substrate 102, a buffer layer 121, a breakdown voltage holding layer 122, p regions 123, n regions 124, p⁺ regions 125, an oxide film 126, source electrodes 111, upper source electrodes 127, a gate electrode 110, and a drain electrode 112 formed on the backside surface of substrate 102. Specifically, buffer layer 121 made of silicon carbide is formed on the front-side surface of substrate 102 made of silicon carbide of n type conductivity. Employed as substrate 102 is a silicon carbide substrate of the present invention, inclusive of silicon carbide substrate 1 described in each of the first and second embodiments. In the case where silicon carbide substrate 1 in each of the first and second embodiments is employed, buffer layer 121 is formed on SiC layer 20 of silicon carbide substrate 1. Buffer layer 121 has n type conductivity, and has a thickness of, for example, 0.5 µm. Further, impurity with n type conductivity in buffer layer 121 has a density of, for example, 5 × 10¹⁷ cm⁻³. Formed on buffer layer 121 is breakdown voltage holding layer 122. Breakdown voltage holding layer 122 is made of silicon carbide of n type conductivity, and has a thickness of 10 µm, for example. Further, breakdown voltage holding layer 122 includes an impurity of n type conductivity at a density of, for example, 5 × 10¹⁵ cm⁻³.

Breakdown voltage holding layer 122 has a surface in which p regions 123 of p type conductivity are formed with a space therebetween. In each of p regions 123, an n⁺ region 124 is formed at the surface layer of p region 123. Further, at a location adjacent to n⁺ region 124, a p⁺ region 125 is formed. Oxide film 126 is formed to extend on n⁺ region 124 in one p region 123, p region 123, an exposed portion of breakdown voltage holding layer 122 between the two p regions 123, the other p region 123, and n⁺ region 124 in the other p region 123. On oxide film 126, gate electrode 110 is formed. Further, source electrodes 111 are formed on n⁺ regions 124 and p⁺ regions 125. On source electrodes 111, upper source electrodes 127 are formed. Moreover, drain electrode 112 is formed on the backside surface of substrate 102, i.e., the surface opposite to its front-side surface on which buffer layer 121 is formed.

Employed as substrate 102 in semiconductor device 101 of the present embodiment is a silicon carbide substrate of the present invention such as silicon carbide substrate 1 described above in the first and second embodiments. Here, as described above, the silicon carbide substrate of the present invention allows for reduced manufacturing cost of semiconductor devices. Hence, semiconductor device 101 is manufactured with the reduced manufacturing cost.

The following describes a method for manufacturing semiconductor device 101 shown in Fig. 8, with reference to Fig. 9-Fig. 13. Referring to Fig. 9, first, a substrate preparing step (S110) is performed. Prepared here is, for example, substrate 102, which is made of silicon carbide and has its main surface corresponding to the (03-38) plane (see Fig. 10). As substrate 102, there is prepared a silicon carbide substrate of the present invention, inclusive of silicon carbide substrate 1 manufactured in accordance with each of the manufacturing methods described in the first and second embodiments.

Alternatively, as substrate 102 (see Fig. 10), a substrate may be employed which has n type conductivity and has a substrate resistance of 0.02 Ωcm.

Next, as shown in Fig. 9, an epitaxial layer forming step (S120) is performed. Specifically, buffer layer 121 is formed on the front-side surface of substrate 102. Buffer layer 121 is formed on SiC layer 20 (see Fig. 1 and Fig. 5) of silicon carbide substrate 1 employed as substrate 102. As buffer layer 121, an epitaxial layer is formed which is made of silicon carbide of n type conductivity and has a thickness of 0.5 µm, for example. Buffer layer 121 has a conductive impurity at a density of, for example, 5 × 10¹⁷ cm⁻³. Then, on buffer layer 121, breakdown voltage holding layer 122 is formed as shown in Fig. 10. As breakdown voltage holding layer 122, a layer made of silicon carbide of n type conductivity is formed using an epitaxial growth method. Breakdown voltage holding layer 122 can have a thickness of, for example, 10 µm. Further, breakdown voltage holding layer 122 includes an impurity of n type conductivity at a density of, for example, 5 × 10¹⁵ cm⁻³.

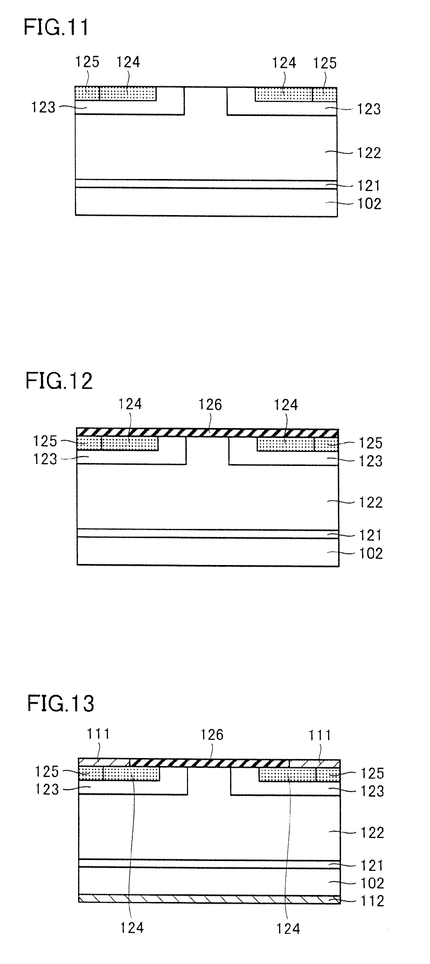

Next, as shown in Fig. 9, an implantation step (S130) is performed. Specifically, an impurity of p type conductivity is implanted into breakdown voltage holding layer 122 using, as a mask, an oxide film formed through photolithography and etching, thereby forming p regions 123 as shown in Fig. 11. Further, after removing the oxide film thus used, an oxide film having a new pattern is formed through photolithography and etching. Using this oxide film as a mask, a conductive impurity of n type conductivity is implanted into predetermined regions to form n⁺ regions 124. In a similar way, a conductive impurity of p type conductivity is implanted to form p⁺ regions 125. As a result, the structure shown in Fig. 11 is obtained.

After such an implantation step, an activation annealing process is performed. This activation annealing process can be performed under conditions that, for example, argon gas is employed as atmospheric gas, heating temperature is set at 1700°C, and heating time is set at 30 minutes.

Next, a gate insulating film forming step (S 140) is performed as shown in Fig. 9. Specifically, as shown in Fig. 12, oxide film 126 is formed to cover breakdown voltage holding layer 122, p regions 123, n⁺ regions 124. and p⁺ regions 125. As a condition for forming oxide film 126, for example, dry oxidation (thermal oxidation) may be performed. The dry oxidation can be performed under conditions that the heating temperature is set at 1200°C and the heating time is set at 30 minutes.

Thereafter, a nitrogen annealing step (S150) is performed as shown in Fig. 9. Specifically, an annealing process is performed in atmospheric gas of nitrogen monoxide (NO). Temperature conditions for this annealing process are, for example, as follows: the heating temperature is 1100°C and the heating time is 120 minutes. As a result, nitrogen atoms are introduced into a vicinity of the interface between oxide film 126 and each of breakdown voltage holding layer 122, p regions 123, n⁺ regions 124, and p⁺ regions 125, which are disposed below oxide film 126. Further, after the annealing step using the atmospheric gas of nitrogen monoxide, additional annealing may be performed using argon (Ar) gas, which is an inert gas. Specifically, using the atmospheric gas of argon gas, the additional annealing may be performed under conditions that the heating temperature is set at 1100°C and the heating time is set at 60 minutes.

Next, as shown in Fig. 9, an electrode forming step (S160) is performed. Specifically, a resist film having a pattern is formed on oxide film 126 by means of the photolithography method. Using the resist film as a mask, portions of the oxide film above n⁺ regions 124 and p⁺ regions 125 are removed by etching. Thereafter, a conductive film such as a metal is formed on the resist film and formed in openings of oxide film 126 in contact with n⁺ regions 124 and p⁺ regions 125. Thereafter, the resist film is removed, thus removing the conductive film's portions located on the resist film (lift-off). Here, as the conductor, nickel (Ni) can be used, for example. As a result, as shown in Fig. 13, source electrodes 111 and drain electrode 112 can be obtained. It should be noted that on this occasion, heat treatment for alloying is preferably performed. Specifically, using atmospheric gas of argon (Ar) gas, which is an inert gas, the heat treatment (alloying treatment) is performed with the heating temperature being set at 950°C and the heating time being set at 2 minutes.

Thereafter, on source electrodes 111, upper source electrodes 127 (see Fig. 8) are formed. Further, drain electrode 112 is formed on the backside surface of substrate 102 (see Fig. 8). Further, gate electrode 110 (see Fig. 8) is formed on oxide film 126. In this way, semiconductor device 101 shown in Fig. 8 can be obtained. Namely, semiconductor device 101 is fabricated by forming the epitaxial layer and the electrodes on SiC layer 20 of silicon carbide substrate 1.

It should be noted that in the third embodiment, the vertical type MOSFET has been illustrated as one exemplary semiconductor device that can be fabricated using the silicon carbide substrate of the present invention, but the semiconductor device that can be fabricated is not limited to this. For example, various types of semiconductor devices can be fabricated using the silicon carbide substrate of the present invention, such as a JFET (Junction Field Effect Transistor), an IGBT (Insulated Gate Bipolar Transistor), and a Schottky barrier diode. Further, the third embodiment has illustrated a case where the semiconductor device is fabricated by forming the epitaxial layer, which serves as an active layer, on the silicon carbide substrate having its main surface corresponding to the (03-38) plane. However, the crystal plane that can be adopted for the main surface is not limited to this and any crystal plane suitable for the purpose of use and including the (0001) plane can be adopted for the main surface.

### [Example]

The following describes an example of the present invention. An experiment was conducted to inspect electric characteristics in the intermediate layer (connection interface) of an actually fabricated silicon carbide substrate of the present invention. The experiment was conducted in the following manner.

First, a silicon carbide substrate of the present invention was fabricated as a sample. The silicon carbide substrate was fabricated in the same manner as in the first embodiment. Specifically, a base substrate and a SiC substrate were prepared. Employed as the base substrate was a substrate having a shape with a diameter φ of 4 inches and a thickness of 300 µm, made of single-crystal silicon carbide with polytype of 4H, and having a main surface corresponding to the (03-38) plane. Further, the base substrate had n type conductivity, and had an n type impurity density of 1 × 10²⁰ cm⁻³. Further, the base substrate had a micro pipe density of 1 × 10⁴ cm⁻², and had a stacking fault density of 1 × 10⁵ cm⁻¹.

Employed as the SiC substrate was a substrate having a planar shape of square with each side of 20 mm, having a thickness of 300 µm, made of single-crystal silicon carbide with a polytype of 4H, and having a main surface corresponding to the (03-38) plane. Further, the SiC substrate had n type conductivity, and had an n type impurity density of 1 × 10¹⁹ cm⁻³. Further, the SiC substrate had a micro pipe density of 0.2 cm⁻² and had a stacking fault density less than 1 cm⁻¹.

Next, on the base substrate, a Si film having a thickness of 100 nm was formed using the sputtering method. Thereafter, the SiC substrate was placed on the Si film to fabricate a stacked substrate. Then, this stacked substrate was heated at 1500°C for 3 hours, thereby converting at least portions of the Si film into silicon carbide to connect the base substrate and the SiC substrate to each other. The atmosphere during the heating was a mixed gas of hydrogen gas and propane, and has a pressure of 1 × 10³ Pa. Further, the flow rate of the hydrogen gas was set at 3 slm, and the flow rate of propane was set at 80 sccm. It should be noted that the flow rate of the hydrogen gas can be set at 1 to 10 slm, and the flow rate of propane can be set at 50 to 500 sccm. With the above-described procedure, the silicon carbide substrate serving as the sample was fabricated.

Next, the main surface of the silicon carbide substrate obtained was polished to achieve a uniform thickness, whereby variation of the thickness (difference between the maximum value and the minimum value of the thickness of the silicon carbide substrate) became 5 µm. Further, ohmic electrodes were formed on both the main surfaces of the silicon carbide substrate. The ohmic electrodes were formed by forming nickel films on the main surfaces thereof and heating them for silicidation. The heat treatment for silicidation can be performed by heating them in an inert gas atmosphere to a temperature of not less than 900°C and not more than 1100°C for not less than 10 minutes and not more than 10 hours. In this experiment, the heat treatment was performed by heating them in an argon atmosphere under an atmospheric pressure to 1000°C for 1 hour. Then, a voltage was applied between the ohmic electrodes to inspect electric characteristics of the connection interface (intermediate layer formed by converting at least portions of the Si film into silicon carbide).

As a result, it was confirmed that ohmic characteristics were obtained in the connection interface. From this, it was confirmed that according to the method for manufacturing the silicon carbide substrate of the present invention, the plurality of substrates made of silicon carbide can be connected to each other while securing ohmic characteristics in the thickness direction thereof.

The silicon carbide substrate of the present invention can be used to fabricate a semiconductor device as described above in the third embodiment. Namely, in the semiconductor device of the present invention, the epitaxial growth layer is formed as an active layer on the silicon carbide substrate manufactured using the method for manufacturing the silicon carbide substrate in the present invention. Explaining from a different point of view, in the semiconductor device of the present invention, the epitaxial growth layer is formed on the silicon carbide substrate of the present invention as an active layer. More specifically, the semiconductor device of the present invention includes: the silicon carbide substrate of the present invention; the epitaxial growth layer formed on the silicon carbide substrate; and the electrodes formed on the epitaxial growth layer. Namely, the semiconductor device of the present invention includes: the base layer made of silicon carbide; the intermediate layer formed on and in contact with the base layer; the SiC layer made of single-crystal silicon carbide and disposed on and in contact with the intermediate layer; the epitaxial growth layer formed on the SiC layer; and the electrodes formed on the epitaxial growth layer. In addition, the intermediate layer contains silicon carbide at least at its region adjacent to the base layer and its region adjacent to the SiC layer, and connects the base layer and the SiC layer to each other.

The embodiments and example disclosed herein are illustrative and non-restrictive in any respect. The scope of the present invention is defined by the terms of the claims, rather than the embodiments described above, and is intended to include any modifications within the scope and meaning equivalent to the terms of the claims.

### INDUSTRIAL APPLICABILITY

A method for manufacturing a silicon carbide substrate, and the silicon carbide substrate in the present invention are particularly advantageously applicable to a method for manufacturing a silicon carbide substrate, and the silicon carbide substrate, each of which achieves reduced cost of manufacturing a semiconductor device using the silicon carbide substrate.

### REFERENCE SIGNS LIST

1, 2: silicon carbide substrate; 10: base layer (base substrate); 20: SiC layer (SiC substrate); 20A: main surface; 30: Si film; 40: intermediate layer; 101: semiconductor device; 102: substrate; 110: gate electrode; 111: source electrode; 112: drain electrode; 121: buffer layer; 122: breakdown voltage holding layer; 123: p region; 124: n⁺ region; 125: p⁺ region; 126: oxide film; 127: upper source electrode.

## Claims

1. A method for manufacturing a silicon carbide substrate (1), comprising the steps of:
preparing a base substrate (10) made of silicon carbide and a SiC substrate (20) made of single-crystal silicon carbide;
forming a Si film (30) made of silicon on and in contact with a main surface of said base substrate (10);
fabricating a stacked substrate by placing said SiC substrate (20) on and in contact with said Si film (30); and
connecting said base substrate (10) and said SiC substrate (20) to each other by heating said stacked substrate to convert, into silicon carbide, at least a region making contact with said base substrate (10) and a region making contact with said SiC substrate (20) in said Si film (30).

2. The method for manufacturing the silicon carbide substrate (1) according to claim 1, further comprising the step of smoothing at least one of main surfaces of said base substrate (10) and said SiC substrate (20), which are to be disposed face to face with each other with said Si film (30) interposed therebetween in the step of fabricating said stacked substrate, the step of smoothing being performed before the step of fabricating said stacked substrate.

3. The method for manufacturing the silicon carbide substrate (1) according to claim 1, wherein said Si film (30) formed in the step of forming said Si film (30) has a thickness of not less than 10 nm and not more than 1 µm.

4. The method for manufacturing the silicon carbide substrate (1) according to claim 1, wherein in the step of connecting said base substrate (10) and said SiC substrate (20) to each other, said stacked substrate is heated in an atmosphere including a gas containing carbon.

5. The method for manufacturing the silicon carbide substrate (1) according to claim 1, wherein in the step of fabricating said stacked substrate, a plurality of said SiC substrates (20) are arranged side by side when viewed in a planar view.

6. The method for manufacturing the silicon carbide substrate (1) according to claim 1, wherein in said stacked substrate, a main surface (20A) of said SiC substrate (20) opposite to said base substrate (10) has an off angle of not less than 50° and not more than 65° relative to a {0001} plane.

7. The method for manufacturing the silicon carbide substrate (1) according to claim 1, wherein:
said base substrate (10) is made of single-crystal silicon carbide, and
in the step of fabricating said stacked substrate, said stacked substrate is fabricated such that main surfaces of said base substrate (10) and said SiC substrate (20), which are disposed face to face with each other with said Si film (30) interposed therebetween, have the same plane orientation.

8. The method for manufacturing the silicon carbide substrate (1) according to claim 1, wherein the step of connecting said base substrate (10) and said SiC substrate (20) to each other is performed without polishing main surfaces of said base substrate (10) and said SiC substrate (20) before the step of connecting said base substrate (10) and said SiC substrate (20) to each other, said main surfaces of said base substrate (10) and said SiC substrate (20) being to be disposed face to face with each other in the step of connecting said base substrate (10) and said SiC substrate (20) to each other.

9. The method for manufacturing the silicon carbide substrate (1) according to claim 1, further comprising the step of polishing a main surface (20A) of said SiC substrate (20), said main surface (20A) corresponding to a main surface (20A) of said SiC substrate (20) to be opposite to said base substrate (10).

10. A silicon carbide substrate (1), comprising:
a base layer (10) made of silicon carbide;
an intermediate layer (40) formed on and in contact with said base layer (10); and
a SiC layer (20) made of single-crystal silicon carbide and disposed on and in contact with said intermediate layer (40),
said intermediate layer (40) containing silicon carbide at least at its region adjacent to said base layer (10) and its region adjacent to said SiC layer (20) and connecting said base layer (10) and said SiC layer (20) to each other.

11. The silicon carbide substrate (1) according to claim 10, wherein a plurality of said SiC layers (20) are arranged side by side when viewed in a planar view.

12. The silicon carbide substrate (1) according to claim 10, wherein:
said base layer (10) is made of single-crystal silicon carbide, and
no micro pipe of said base layer (10) is propagated to said SiC layer (20).

13. The silicon carbide substrate (1) according to claim 10, wherein a main surface (20A) of said SiC layer (20) opposite to said base layer (10) has an off angle of not less than 50° and not more than 65° relative to a {0001} plane.

14. The silicon carbide substrate (1) according to claim 10, wherein:
said base layer (10) is made of single-crystal silicon carbide, and
main surfaces of said base layer (10) and said SiC layer (20), which are disposed face to face with each other with said intermediate layer (40) interposed therebetween, has the same plane orientation.

15. The silicon carbide substrate (1) according to claim 10, wherein said SiC layer (20) has a main surface (20A) opposite to said base layer (10) and polished.
